Europäisches Patentamt

European Patent Office

Office européen des brevets

(19)

(11) **EP 1 028 534 A1**

(12) **EUROPEAN PATENT APPLICATION**

(43) Date of publication:
**16.08.2000 Bulletin 2000/33**

(51) Int Cl.⁷: **H03M 13/45**, H03M 13/25

(21) Application number: **00200353.1**

(22) Date of filing: **03.02.2000**

(84) Designated Contracting States:
**DE FR GB**
Designated Extension States:
**AL LT LV MK RO SI**

(30) Priority: **09.02.1999 GB 9902810**

(71) Applicant: **Tandberg Television ASA**
**1326 Lysaker (NO)**

(72) Inventors:
• **Markarian, Garegin**
  **Southampton, Hampshire SP16 7HN (GB)**

• **Pickavance, Keith**
  **Romsey, Hampshire SO51 7JRW (GB)**
• **Waddington, Simon**
  **Southampton, Hampshire SO17 2HQ (GB)**

(74) Representative: **Sturt, Clifford Mark**
**Miller Sturt Kenyon**
**9 John Street**
**London WC1N 2ES (GB)**

(54) **Indicating the reliability of uncoded bits in an input digital signal**

(57)    The present invention relates to indicating the reliability of the uncoded bits in an input signal representing digital symbols of encoded and uncoded bits.

The encoded bits are decoded to generate reference signals representing a plurality of estimates for each of the symbols. The symbol estimates are compatible with the encoded bits. The input signal is compared with the reference signals to determine the closest estimate of each symbol and the reliability of the uncoded bits are indicated by the differences between the input signal and the closest symbol estimates.

The invention is applicable to indicating the reliability of the uncoded bits in an input signal in which the digital symbols are represented by quadrature signal components of the input signal. In this case the reference signals representing the estimates for each symbol are comparable reference quadrature signal components. The closest symbol estimate is determined from the minimum Euclidean distance between the quadrature components of the input signal and the reference quadrature components.

## Fig.1.

**Description**

The present invention relates to indicating the reliability of the uncoded bits in an input signal representing digital symbols of encoded and uncoded bits.

In the transmission and decoding of encoded digital signals there is an ever increasing demand for higher information rates and better error performance. This demand has dictated the use of higher order modulation techniques combined with error control coding. In particular, in the field of digital television signal transmission, the use of pragmatic trellis coded modulation schemes is recommended as a standard in Europe with variable data rates R = 1/2, 2/3 and so on up to 8/9 and M-ary modulation schemes where M = 8 and M = 16. A similar approach has been accepted in the USA where a digital television standard is recommended using pragmatic trellis coded modulation with a data rate R = 1/2 and a vestigial sideband (VSB) modulation scheme which is an 8VSB or a 16VSB modulation scheme.

Conventional pragmatic trellis coded modulation and decoding provides different levels of error protection for different bits of binary data. In the case of 8-PSK modulation with a data rate of 2/3, for example, for every encoded (protected) bit there is one uncoded or unprotected bit. In the case of 8-PSK modulation where the data rate is 5/6, for every one encoded (protected) bit there are four uncoded or unprotected bits. The uncoded bits are less reliable in comparison with the encoded bits and it would therefore be desirable to devise ways of providing reliability estimates of the uncoded bits.

In known soft output Viterbi decoder techniques, reliability values are provided, but only for encoded bits. The application of such decoder techniques to pragmatic trellis coded modulation is therefore not readily apparent. Conventional erasure decoders are prone to the generation of "wrong erasures" in which correctly received symbols with low indicated reliability are incorrectly signalled as erasures. This reduces the error control capability of the code.

It is an aim of the present invention to provide an improvement in the indication of the reliability of uncoded bits in an input digital signal comprising symbols representing encoded and uncoded bits.

According to the present invention, there is now provided a method of indicating the reliability of the uncoded bits in an input signal representing digital symbols of encoded and uncoded bits, the method comprising the steps of: decoding the encoded bits to generate reference signals representing a plurality of estimates for each of the symbols, the symbol estimates being compatible with the encoded bits; comparing the input signal with the reference signals to determine the closest estimate of each symbol; and, providing indications of the reliability of the uncoded bits from the differences between the input signal and the closest symbol estimates.

Further according to the present invention, there is provided apparatus for indicating the reliability of the uncoded bits in an input signal representing digital symbols of encoded and uncoded bits, the apparatus comprising: a decoder for decoding the encoded bits to generate reference signals representing a plurality of estimates for each of the symbols, the symbol estimates being compatible with the encoded bits; a comparator for comparing the input signal with the reference signals to determine the closest estimate of each symbol; and, means providing indications of the reliability of the uncoded bits from the differences between the input signal and the closest symbol estimates.

The invention will now be described, by way of example, with reference to the accompanying drawings in which:

Figure 1 shows a block diagram of a known pragmatic trellis coded 8-PSK modulator using a data rate of 2/3;

Figure 1a shows a block diagram of a concatenated modulation system employing the modulator of Figure 1;

Figure 2 shows a block diagram of a known pragmatic trellis coded 8-PSK modulator using a data rate of 5/6;

Figure 2a shows a block diagram of a concatenated modulation system employing the modulator of Figure 2;

Figures 3 and 4 show block diagrams of decoder apparatus for use in decoding the modulated signals generated by the modulators of Figures 1 and 2 respectively;

Figures 3a and 4a show block diagrams of demodulating systems for demodulating the signals generated by the modulators in Figures 1a and 2a respectively;

Figures 5 and 6 show decoder apparatus, according to the present invention, for decoding the modulated signals generated by means of the modulators in Figures 1 and 2 respectively, and giving additional information on erasure locations;

Figures 5a and 6a show decoder apparatus for decoding the modulated signals generated by means of the modulators in Figures 1 a and 2a;

Figure 7 shows a block diagram of an erasure decoder, according to the invention, included in the decoder apparatus of Figures 5a and 6a;

Figure 8 shows a soft decision metric generator included in the decoder apparatus of Figures 5 and 6; and

Figure 9 shows a known pragmatic trellis coded modulator in conjunction with an interference filter pre-coder and 8-level vestigial side band modulation.

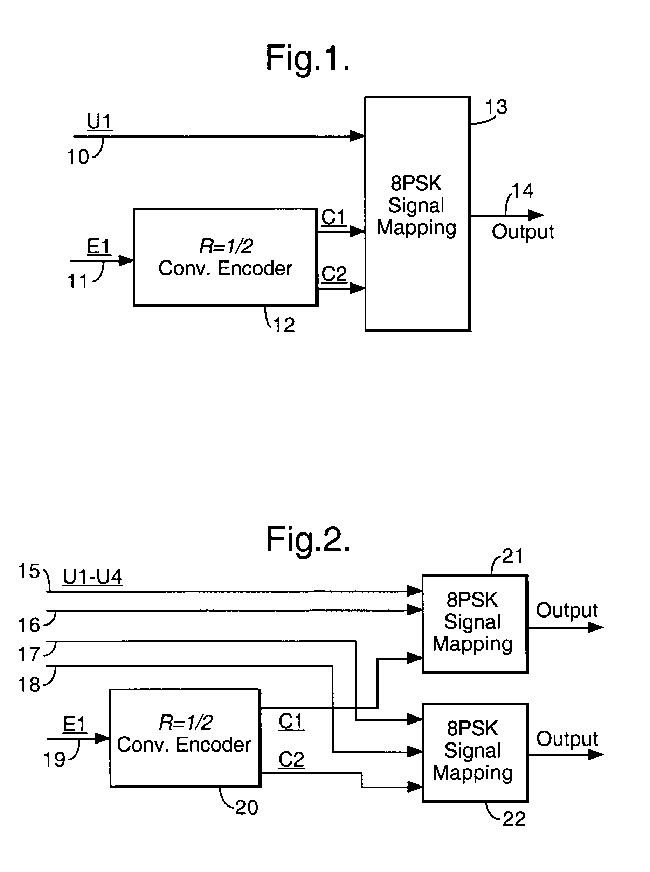

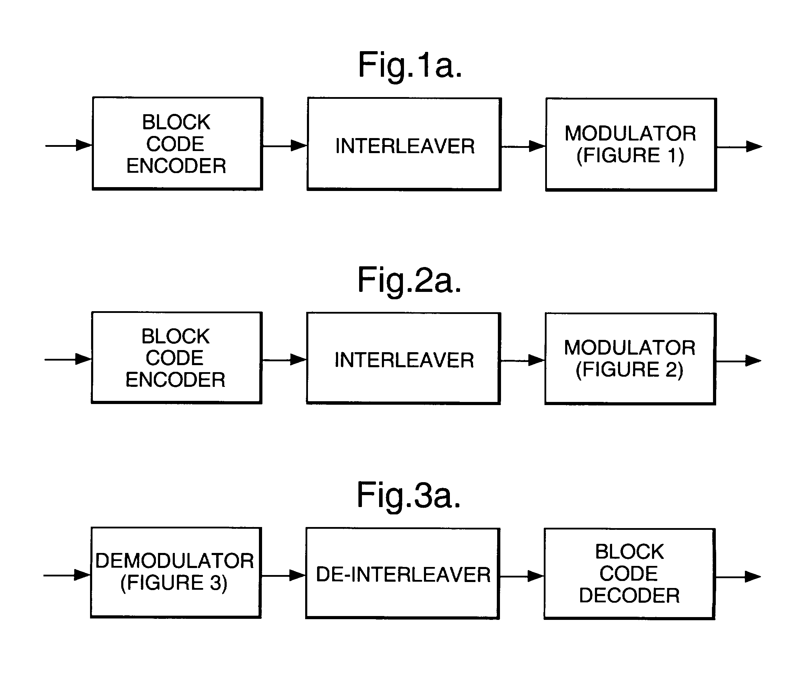

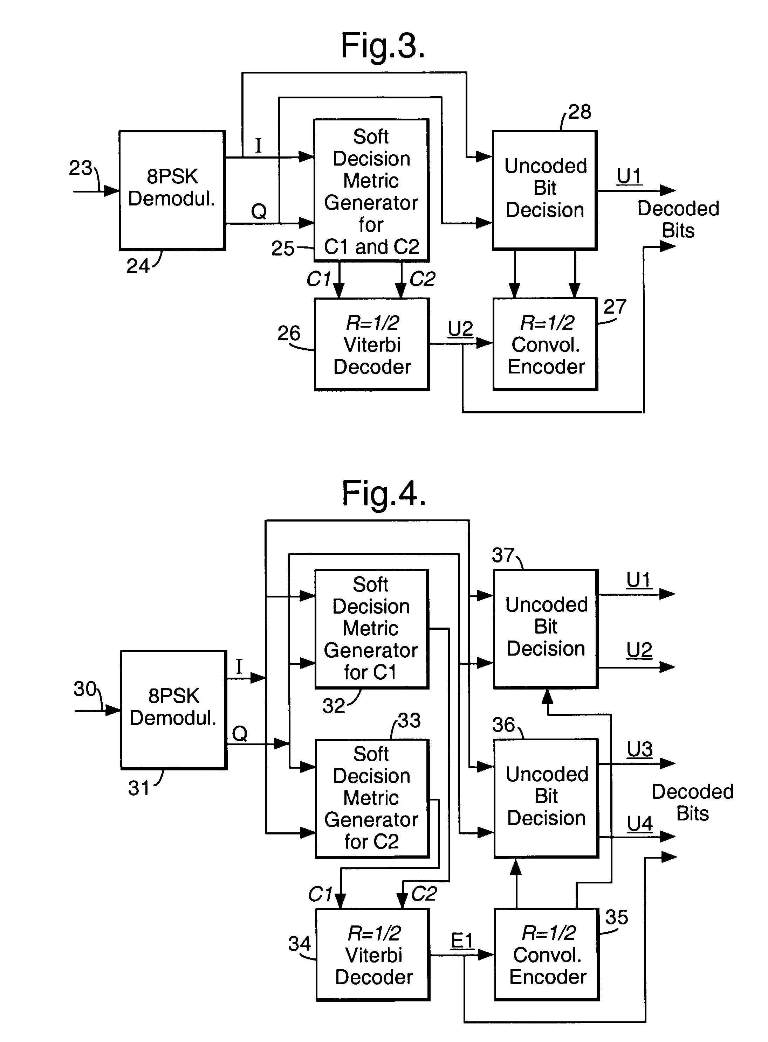

In Figure 1, an input bit U1 of an input symbol is applied to an input terminal 10. Another bit E1 of the symbol is applied to an input terminal 11. The input terminal 11 is connected to supply the bit E1 to a convolutional encoder 12 having a data rate R = 1/2. The output from the convolutional encoder consists of two bits C1 and C2 for each input bit E1. C1 and C2 are bits which represent the convolutional encoding of the input bit E1. The bits U1, C1 and C2 are supplied to an 8-PSK signal mapping module 13 which maps the three bits to an 8-PSK modulation of the output signal on the output terminal 14. The output modulated signal includes symbols which represent one uncoded bit U1 and two convolutional encoded bits C1 and C2. The output modulated signal is transmitted to a decoder which will be described with reference to Figure 3.

Figure 1a shows the modulator of Figure 1 included in a concatenated modulation system which also includes a block code encoder and an interleaver.

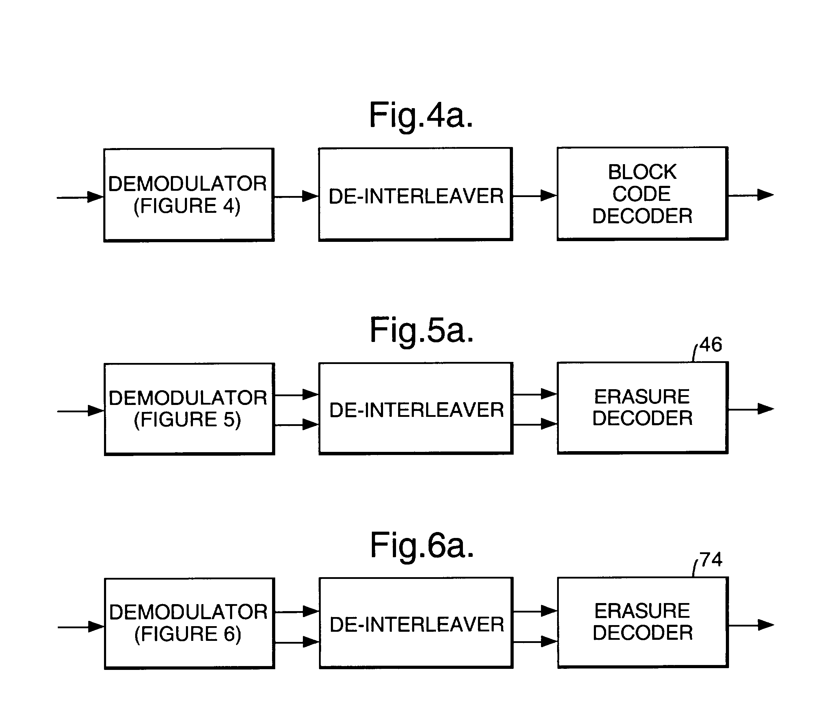

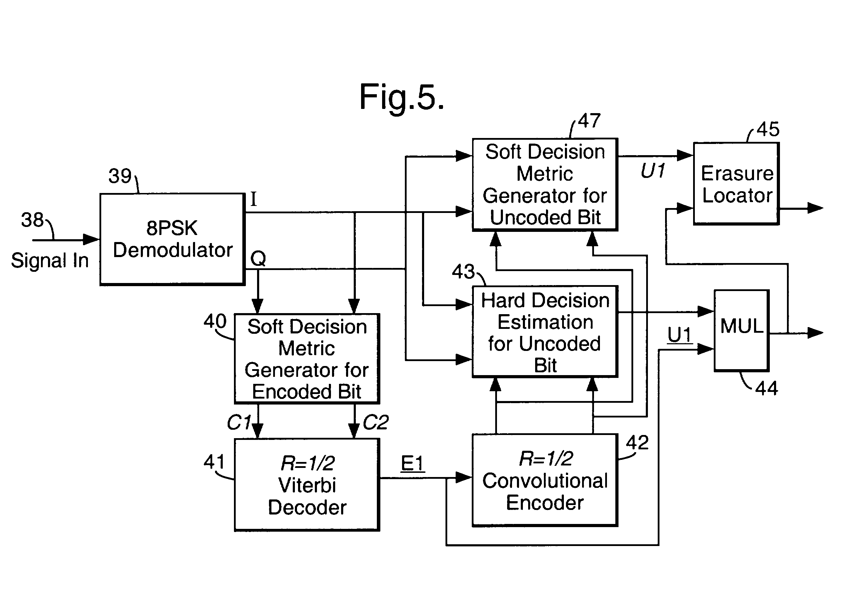

In Figure 2, four input bits U1 to U4 are applied in parallel to input terminals 15 to 18 respectively and an input bit E1 is applied to an input terminal 19. The input terminal 19 is connected to supply the bit E1 to a convolutional encoder 20 having a data rate R = 1/2. The output from the convolutional encoder 20 consists of two bits C1 and C2 for each input bit E1. C1 and C2 represent the convolutional encoding of the input bit E1. The input bits U1 and U2 and the bit C1 are applied as input to an 8-PSK mapping circuit 21 while the input bits U3, U4 and the bit C2 are applied to an 8-PSK mapping circuit 22. Each of the mapping circuits 21 and 22 maps its respective three bits to a symbol of an 8-PSK modulated output. The symbols are interleaved before onward transmission to a decoder which will be described with reference to Figure 4. It will be apparent that the modulator of Figure 2 has a data rate R = 5/6. The two output symbols represent the four uncoded bits U1 to U4 and the two convolutionally encoded bits C1 and C.

In Figure 2a the modulator of Figure 2 is shown included in a concatenated modulation system which also includes a block code and an interleaver.

In Figure 3, a decoder has an input terminal 23 to receive the 8-PSK modulated signal output from the encoder of Figure 1. A demodulator 24 demodulates the 8-PSK modulated signal to produce I and Q quadrature components. The I and Q components are supplied to a module 25 which applies a soft-decision metric to the I and Q components to regenerate the bits C1 and C2 of each symbol. The bits C1 and C2 are applied to a Viterbi decoder 26 which decodes the bits C1 and C2 to reproduce the encoded bit E1 of each symbol. The bit E1 is supplied to a convolution encoder 27 of data rate R = 1/2 to generate two convolutionally encoded bits for each decoded bit E1. The convolutionally encoded bits from the encoder 27 are applied to a module 28.

The module 28 receives the quadrature components I and Q from the demodulator 24 and produces a bit decision for each symbol. The bit decision specifies the uncoded bit U1 and is determined by the I and Q components from the demodulator 24 and the convolutionally encoded bits from the encoder 27. The output E1 from the decoder 26 and the output U1 from the module 28 represent the decoded output from the decoder.

In Figure 3a the demodulator of Figure 3 is shown incorporated into a system which also includes a de-interleaver and a block code decoder.

In Figure 4, a decoder has an input terminal 30 to receive the 8-PSK modulated signal output from the encoder of Figure 2. A demodulator 31 demodulates the 8-PSK modulated signal to produce I and Q quadrature components. The I and Q components are supplied to modules 32 and 33 which apply soft decision metrics to regenerate the bits C1 and C2 respectively. The bits C1 and C2 are applied to a Viterbi decoder 34 of rate R = 1/2 which decodes the bits C1 and C2 to reproduce the encoded bit E1. The bit E1 is supplied to a convolution encoder 35 of data rate R = 1/2 to generate two convolutionally encoded bits for each decoded bit E1. The two convolutionally encoded bits from the encoder 35 are applied to two modules 36 and 37 respectively.

The module 36 receives the quadrature components I and Q from the demodulator 31 and produces bit decisions specifying the uncoded bits U1 and U2. The bit decisions depend on the I and Q components from the demodulator 31 and the convolutionally encoded bit from the encoder 35. The module 37 receives the quadrature components I and Q from the demodulator 31 and produces bit decisions specifying the uncoded bits U3 and U4. The bit decisions produced by the module 37 depend on the I and Q components from the demodulator 31 and the convolutionally encoded bit from the encoder 35. The output E1 from the decoder 34 and the outputs U1 to U4 from the modules 36 and 37 represent the decoded output from the decoder.

In Figure 4a the demodulator of Figure 4 is shown incorporated into a system which also includes a de-interleaver and a block code decoder.

For known apparatus such as those of Figures 3 and 4 it is also known for each bit regenerated by application of a soft decision metric to have an associated measure of the probability of the bit having been generated correctly. This measure is known as the reliability value.

Figure 5 shows a decoder for decoding the modulated signal generated by the modulator of Figure 1. The decoder of Figure 5 is an improvement, according to the present invention, over the decoder of Figure 3, in that it also outputs reliability information that can be used by an outer erasure decoder. The decoder of Figure 5 receives the 8-PSK modulated signal from the modulator of Figure 1 through an input terminal 38. A demodulator 39 demodulates the 8-PSK modulated signal to produce I and Q quadrature components. The I and Q components are supplied to a module 40 which applies a soft decision metric to the I and Q components to regenerate the bits C1 and C2 of each symbol. The bits C1 and C2 are applied to a Viterbi decoder 41 which decodes the bits C1 and C2 to reproduce the encoded bit E1 of each symbol. The bit E1 is supplied to a convolutional encoder 42 of data rate R = 1/2 to generate two convolutionally encoded bits for each decoded bit E1. The convolutionally encoded bits from the encoder 42 are applied to a module 43.

The module 43 receives the quadrature components I and Q from the demodulator 39 and produces a hard decision estimation of the uncoded bit in each symbol. The hard bit decision specifies the uncoded bit U1 and is determined by the I and Q components from the demodulator 39 and the convolutionally encoded bits from the encoder 42. The output E1 from the Viterbi decoder 41 is the same as the output which is produced by the Viterbi decoder 26 of Figure 3 and the output U1 from the module 43 is the same as the output which is produced by the module 28 of Figure 3. In the Figure 5 decoder, however these outputs are supplied to a multiplexer 44 which multiplexes the bits and supplies them to an erasure locator 45.

A module 47 receives the I and Q quadrature components from the demodulator 39 in parallel with the modules 40 and 43. The module 47 applies a soft decision metric to generate a soft decision estimation for the uncoded bit by reference to the I and Q components and by reference to the output from the convolutional encoder 42. The soft decision estimation from the module 47 is supplied as a second input to the erasure locator 45. The erasure locator 45 operates in conventional manner to signal erasure locations in the symbols received at the input terminal 38 based on the inputs from the multiplexer 44 and from the module 47. For every soft value of U1 that is received by the erasure locator 45, there are two hard decision values U1 and E1. The erasure locator accumulates 8 hard decision values, 4 soft decision values and generates one symbol from the GF($2^8$). If the lowest reliability value is acknowledged as an erasure, the whole symbol will be treated as an erasure and the erasure locator generates a value of "1". If the received symbol is acknowledged as reliable, the erasure locator generates a "0".

Figure 5a shows a concatenated demodulation scheme for the modulated signal produced by the modulator shown in Figure 1a. According to the present invention, this gives a performance improvement over the demodulator of Figure 3a by passing erasure locations to the outer block code decoder 46.

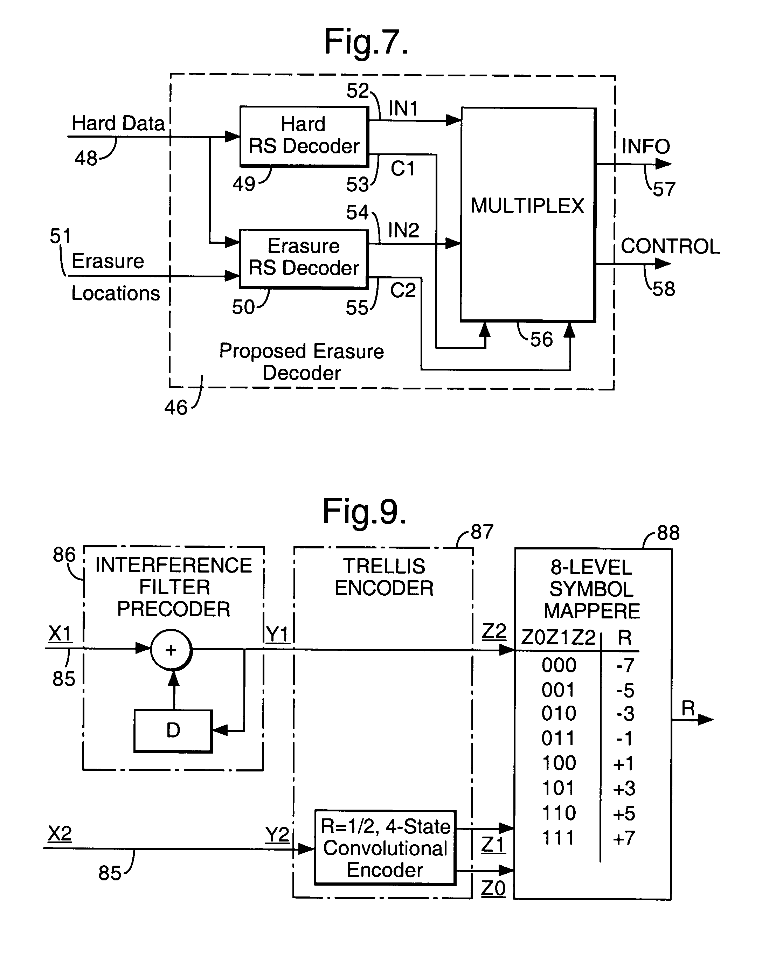

The erasure decoder 46 is shown in further detail in Figure 7. The hard data from the multiplexer 44 is applied at an input terminal 48 to a hard Reed Solomon decoder 49 and an erasure Reed Solomon decoder 50. The erasure locations from the erasure locator 45 are applied to an input terminal 51 to the erasure decoder 50. Each of the decoders 49 and 50 provides two output signals. The decoder 49 provides an output signal IN1 on a terminal 52 which represents the decoded information symbol and a control signal C1 on a terminal 53. The control signal C1 has a value of 0 if the decoder 49 is capable of correctly decoding the received code and has a value of 1 if the number of errors in the received code exceeds the error control capability of the code. The decoder 50 provides an output signal IN2 on a terminal 54 which represents the decoded information symbol and a control signal C2 on a terminal 55. The control signal C2 has a value of 0 if the decoder 50 is capable of correctly decoding the received code and has a value of 1 if the number of errors in the received code exceeds the error control capability of the code.

The signals IN1, IN2, C1 and C2 on the terminals 52 to 55 are supplied to a multiplexer 56. The multiplexer 56 produces an INFO signal on an output terminal 57 and a control signal on an output terminal 58 according to the following look-up Table I;

TABLE I

| Control Signal C1 | Control Signal C2 | INFO Signal Out | CONTROL Signal Out |
|---|---|---|---|
| 0 | 0 | IN1 | 0 |
| 0 | 1 | IN1 | 0 |
| 1 | 0 | IN2 | 0 |
| 1 | 1 | IN1 | 1 |

The logic of the overall decoding can be described in relation to the look-up Table I as follows:

If both the hard decision decoder 49 and the erasure decoder 50 are capable of correcting the received codeword, the output from the hard decision decoder 49 is selected in preference to the output from the erasure decoder 50 and passed to the information terminal 57. The control terminal 58 receives a control signal 0;
If only the hard decision decoder 49 is capable of correcting the received codeword, the output from the hard decision decoder is selected and passed to the information terminal 57.

The control terminal 58 receives a control signal 0;

If only the hard decision decoder 49 reports a failure to decode, the output from the erasure decoder is selected and passed to the information terminal 57. The control terminal 58 receives a control signal 0;
If both decoders 49 and 50 report failure, the overall decoder reports failure by putting a control signal 1 on the control terminal 58 and the output from the hard decision decoder 49 on the information terminal 57.

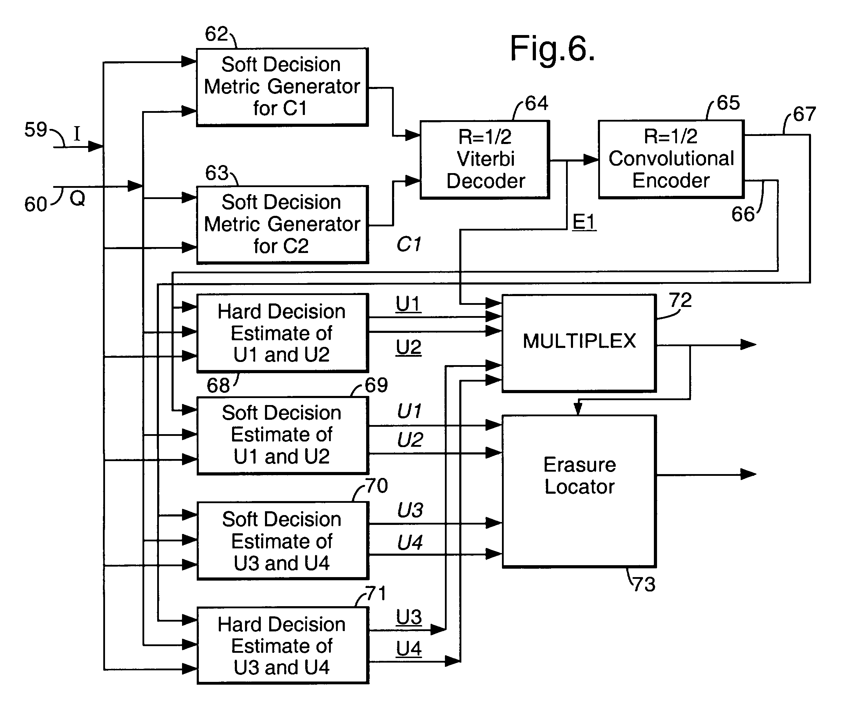

Figure 6 shows a decoder for decoding the modulated signal generated by the modulator of Figure 2. The decoder of Figure 6 is an improvement, according to the present invention, over the decoder of Figure 4, in that it outputs additional reliability information that can be used by an outer erasure decoder. The decoder of Figure 6 receives the 8-PSK modulated signal from the modulator of Figure 2. The decoder includes a demodulator (not shown) which demodulates the 8-PSK modulated signal to produce I and Q quadrature components on terminals 59 and 60. The I and Q components are supplied to modules 62 and 63 which apply soft decision metrics to regenerate the bits C1 and C2 respectively. The bits C1 and C2 are applied to a Viterbi decoder 64 of rate R = 1/2 which decodes the bits C1 and C2 to reproduce the encoded bit E1 of each symbol. The bit E1 is supplied to a convolution encoder 65 of data rate R = 1/2 to generate two convolutionally encoded bits for each decoded bit E1. The two convolutionally encoded bits from the encoder 65 are applied to two terminals 66 and 67 respectively.
The terminal 66 is connected to modules 68 and 69 and the terminal 67 is connected to modules 70 and 71. The modules 68, 69, 70 and 71 are connected to receive the I and Q quadrature components from the input terminals 59 and 60. The modules 68 and 69 produce hard and soft decision estimates of the bits U1 and U2 and the modules 70 and 71 produce hard and soft decision estimates of the bits U3 and U4. The hard decision estimates U1 to U4 and the estimate of E1 are applied to a multiplexer 72. The soft decision estimates U1 to U4 are applied to an erasure locator 73.
Figure 6a shows a concatenated demodulation scheme for the modulated signal produced by the modulator in Figure 2a. According the present invention, this gives a performance improvement over the modulator of Figure 4a, by passing erasure locations to the outer block code. The erasure decoder 74 is as shown in Figure 7, the construction and operation of which has already been described.

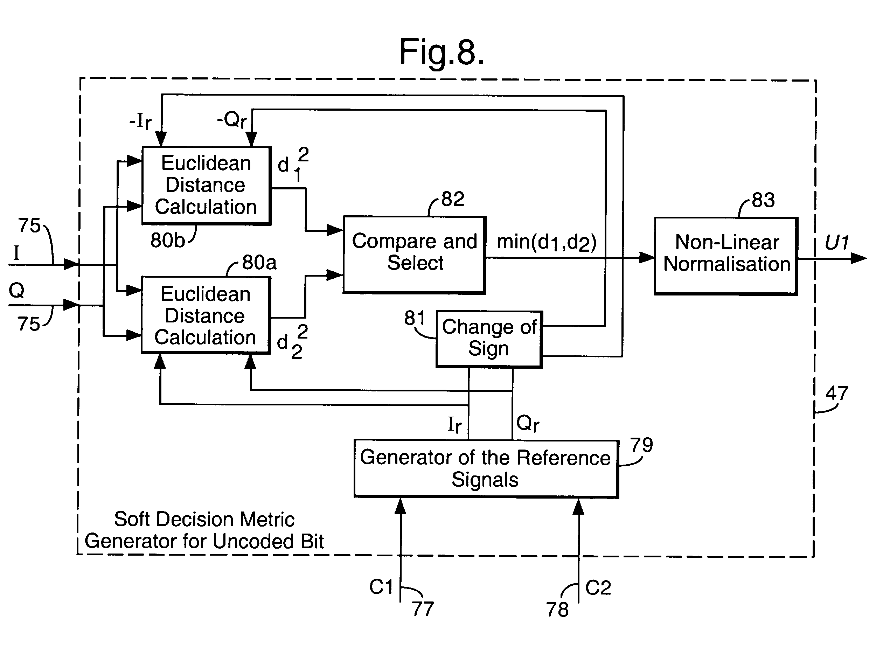

Figure 8 shows the construction of the module 47 in the decoder of Figure 5. The I and Q quadrature components from the demodulator 39 are supplied to the module 47 through terminals 75 and 76. The convolutionally encoded bits C1 and C2 from the encoder 42 are supplied through terminals 77 and 78. The terminals 77 and 78 are connected to a reference signal generator 79 which generates reference signals $I_R$ and $Q_R$ according to the following Table II:

TABLE II

| C1 | C2 | $I_R$; $Q_R$ |
|----|----|----|
| 0 | 0 | $(\cos\pi/8; \sin\pi/8)$ |
| 0 | 1 | $(\cos3\pi/8; \sin3\pi/8)$ |
| 1 | 0 | $(\cos\pi/8; -\sin\pi/8)$ |
| 1 | 1 | $(\cos3\pi/8; -\sin3\pi/8)$ |

The signals $I_R$ and $Q_R$ are applied to a Euclidean distance calculating module 80a and to a change of sign module 81. The module 81 changes the signs of the signals $I_R$ and $Q_R$ to produce signals $-I_R$ and $-Q_R$ which are applied to a Euclidean distance calculating module 80b. The received signal components I and Q on the input terminals 75 and 76 are applied to the modules 80a and 80b. Each module calculates the Euclidean distance between the received signal components I and Q and the reference signals from the generator 79 to produce output signals $d_1^2$ and $d_2^2$. The distance calculations for $d_1^2$ and $d_2^2$ are made according to the formulae:

$$d_1^{\,2} = (I - I_R)^2 + (Q - Q_R)^2$$

and

$$d_2{}^2 = (I + I_R)^2 + (Q + Q_R)^2$$

The signals $d_1{}^2$ and $d_2{}^2$ are applied to a compare and select block 82 which compares those signals and selects the minimum value $\left|d_1{}^2 - d_2{}^2\right|$ between the calculated Euclidean distances. The selected value is normalised by means of a module 83 with reference to an erasure threshold Ao. If $\left|d_1{}^2 - d_2{}^2\right| < A_0$ an erasure is declared.

The value of $A_0$ is defined in relation to the channel conditions. The reliability value of the uncoded bit is a complex function which depends on the probability density function of the noise, signal-to-noise ratio in the channel and the set partitioning of the pragmatic trellis coded modulation. The normalisation provides good matching for the Additive White Gaussian Channel Noise.

In Figure 9, input symbols comprising bits X1 and X2 are entered on lines 84 and 85 in a first stage. An interference filter precoder 86 is used to precode the bits on line 84. In a second stage, the bits of the symbols are labelled Y1 and Y2 and enter a trellis encoder 87 in which the Y2 bits are encoded by means of a 4-state convolutional encoder having a data rate R = 1/2. The output bits from the trellis encoder, labelled Z0, Z1, and Z2 are applied to an 8-level symbol mapper 88 which maps the values of the bits Z0, Z1 and Z2 to values R for an 8-VSB modulation. It will be apparent that the arrangement shown in Figure 9 is similar to the block diagram of figure 1 for 8PSK and R = 2/3 with minor differences for the precoding of the uncoded bit and trellis structure of the R = 1/2 convolutional encoder. Thus, the proposed partial soft output pragmatic decoder for 8 PSK and R = 2/3 shown in Figure 5 can be used (after appropriate alterations in the demodulator) for the decoding of signals produced by the construction of Figure 9.

**Claims**

1. A method of indicating the reliability of the uncoded bits in an input signal representing digital symbols of encoded and uncoded bits, the method comprising the steps of:

   decoding the encoded bits to generate reference signals representing a plurality of estimates for each of the symbols, the symbol estimates being compatible with the encoded bits;
   comparing the input signal with the reference signals to determine the closest estimate of each symbol; and, providing indications of the reliability of the uncoded bits from the differences between the input signal and the closest symbol estimates.

2. A method as claimed in Claim 1 which is applied to indicating the reliability of the uncoded bits in an input signal in which the digital symbols are represented by quadrature signal components of the input signal and in which the step of decoding the encoded bits to generate reference signals representing a plurality of estimates for each symbol includes generating a plurality reference quadrature signal components.

3. A method as claimed in Claim 2 which is applied to indicating the reliability of the uncoded bits in an input signal in which the digital symbols are represented by 8-PSK modulation and there is one uncoded bit in each symbol.

4. A method as claimed in Claim 2 which is applied to indicating the reliability of the uncoded bits in an input signal in which the digital symbols are represented by 8-PSK modulation and there are two uncoded bits in each symbol.

5. A method as claimed in Claim 2, 3 or 4 in which the step of comparing the input signal with the reference signals to determine the closest estimate of each symbol comprises determining the minimum Euclidean distance between the quadrature components of the input signal and the plurality of reference quadrature components.

6. A method as claimed in any one of the preceding claims comprising the further step of normalising the indications of the reliability of the encoded bits.

7. A method as claimed in Claim 6, comprising the further step of indicating an erasure of each symbol for which the indication of reliability falls below a threshold.

8. A method as claimed in any one of the preceding claims which is applied to indicating the reliability of the uncoded bits in an input signal which is a digital television signal.

9. Apparatus for indicating the reliability of the uncoded bits in an input signal representing digital symbols of encoded and uncoded bits, the apparatus comprising:

a decoder for decoding the encoded bits to generate reference signals representing a plurality of estimates for each of the symbols, the symbol estimates being compatible with the encoded bits;
a comparator for comparing the input signal with the reference signals to determine the closest estimate of each symbol; and,
means providing indications of the reliability of the uncoded bits from the differences between the input signal and the closest symbol estimates.

10. Apparatus as claimed in Claim 9 which is adapted to indicate the reliability of the uncoded bits in an input signal in which the digital symbols are represented by quadrature signal components of the input signal and in which the decoder is adapted to generate the reference signals in the form of reference quadrature signal components.

11. Apparatus as claimed in Claim 10 which is adapted to indicate the reliability of the uncoded bits in an input signal in which the digital symbols are represented by 8-PSK modulation and there is one uncoded bit in each symbol.

12. Apparatus as claimed in Claim 10 which is adapted to indicate the reliability of the uncoded bits in an input signal in which the digital symbols are represented by 8-PSK modulation and there are two uncoded bits in each symbol.

13. Apparatus as claimed in Claim 10, 11 or 12 in which the comparator determines the closest estimate of each symbol by determining the minimum Euclidean distance between the quadrature components of the input signal and the reference quadrature components from the decoder.

14. Apparatus as claimed in any one of Claims 9 to 13 further comprising a normaliser for normalising the indications of the reliability of the encoded bits.

15. Apparatus as claimed in Claim 14, further comprising a thresholder for applying a threshold to the indications of reliability.

16. Apparatus as claimed in any one of Claims 9 to 15 which is adapted to indicate the reliability of the uncoded bits in an input signal which is a digital television signal.

# Fig.1.

U1
10

E1
11 → | $R=1/2$ Conv. Encoder | → C1 / C2 → | 8PSK Signal Mapping | 13 → Output 14
12

# Fig.2.

15 ) U1-U4
16
17
18

E1
19 → | $R=1/2$ Conv. Encoder | → C1 / C2
20

| 8PSK Signal Mapping | 21 → Output

| 8PSK Signal Mapping | 22 → Output

Fig. 1a.

BLOCK CODE ENCODER → INTERLEAVER → MODULATOR (FIGURE 1)

Fig.2a.

BLOCK CODE ENCODER → INTERLEAVER → MODULATOR (FIGURE 2)

Fig.3a.

DEMODULATOR (FIGURE 3) → DE-INTERLEAVER → BLOCK CODE DECODER

# Fig.3.

# Fig.4.

## Fig.4a.

```
→  ┌──────────────┐    ┌──────────────┐    ┌──────────────┐
   │ DEMODULATOR  │ →  │ DE-INTERLEAVER │ → │    BLOCK     │ →
   │  (FIGURE 4)  │    │              │    │    CODE      │
   └──────────────┘    └──────────────┘    │   DECODER    │
                                           └──────────────┘
```

## Fig.5a.

```
                                                          46
→  ┌──────────────┐    ┌──────────────┐    ┌──────────────┐
   │ DEMODULATOR  │ →  │ DE-INTERLEAVER │ → │   ERASURE    │ →
   │  (FIGURE 5)  │ →  │              │ → │   DECODER    │
   └──────────────┘    └──────────────┘    └──────────────┘
```

## Fig.6a.

```
                                                          74
→  ┌──────────────┐    ┌──────────────┐    ┌──────────────┐
   │ DEMODULATOR  │ →  │ DE-INTERLEAVER │ → │   ERASURE    │ →
   │  (FIGURE 6)  │ →  │              │ → │   DECODER    │
   └──────────────┘    └──────────────┘    └──────────────┘
```

EP 1 028 534 A1

# Fig.5.

EP 1 028 534 A1

## Fig.6.

# Fig.7.

Hard Data
48

Hard
RS Decoder
52 IN1
49
53 C1

51
Erasure
Locations

Erasure
RS Decoder
54 IN2
50
55 C2

MULTIPLEX
56

INFO
57

CONTROL
58

Proposed Erasure
Decoder
46

# Fig.9.

86
INTERFERENCE
FILTER
PRECODER

X1
85

+

D

Y1

87
TRELLIS
ENCODER

88
8-LEVEL
SYMBOL
MAPPERE

Z2

X2
85

Y2

R=1/2, 4-State
Convolutional
Encoder

Z1

Z0

| Z0Z1Z2 | R |
|--------|-----|
| 000 | -7 |
| 001 | -5 |
| 010 | -3 |
| 011 | -1 |
| 100 | +1 |
| 101 | +3 |
| 110 | +5 |
| 111 | +7 |

R

# Fig.8.

Soft Decision Metric Generator for Uncoded Bit

EP 1 028 534 A1

**European Patent Office**

**EUROPEAN SEARCH REPORT**

Application Number

EP 00 20 0353

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 0 652 643 A (TOKYO SHIBAURA ELECTRIC CO) 10 May 1995 (1995-05-10)<br>* column 1, line 5 - line 9 *<br>* column 4, line 1 - column 5, line 6 *<br>* column 8, line 22 - column 9, line 44 *<br>--- | | H03M13/45<br>H03M13/25 |
| A | WANG HUA ET AL: "A Concatenating Coding Scheme Employing Pragmatic Multidimensional Trellis Code and RS Code for Satellite Communications" INTERNATIONAL CONFERENCE ON COMMUNICATION TECHNOLOGY ICCT'98, 22 - 24 October 1998, pages S38.10.1-S38.10.4, XP002136537 Beijing, China<br>--- | | |
| A | FR 2 754 960 A (MITSUBISHI ELECTRIC CORP) 24 April 1998 (1998-04-24)<br>--- | | |
| A | US 4 827 489 A (AMANO TETSUYA ET AL) 2 May 1989 (1989-05-02)<br>----- | | |
| | | | **TECHNICAL FIELDS SEARCHED** (Int.Cl.7)<br><br>H03M<br>H04L |

The present search report has been drawn up for all claims

| Place of search | Date of completion of the search | Examiner |
|---|---|---|
| THE HAGUE | 28 April 2000 | Ogor, M |

**ANNEX TO THE EUROPEAN SEARCH REPORT
ON EUROPEAN PATENT APPLICATION NO.**

EP 00 20 0353

This annex lists the patent family members relating to the patent documents cited in the above-mentioned European search report.
The members are as contained in the European Patent Office EDP file on
The European Patent Office is in no way liable for these particulars which are merely given for the purpose of information.

28-04-2000

| Patent document cited in search report | | Publication date | Patent family member(s) | | Publication date |
|---|---|---|---|---|---|
| EP 0652643 | A | 10-05-1995 | JP | 7131493 A | 19-05-1995 |
| | | | JP | 7131494 A | 19-05-1995 |
| | | | CA | 2134996 A,C | 05-05-1995 |
| | | | KR | 181983 B | 15-04-1999 |
| | | | US | 5651032 A | 22-07-1997 |
| FR 2754960 | A | 24-04-1998 | JP | 10178355 A | 30-06-1998 |
| | | | CA | 2217044 A | 18-04-1998 |
| | | | CN | 1181663 A | 13-05-1998 |
| US 4827489 | A | 02-05-1989 | JP | 2051223 C | 10-05-1996 |
| | | | JP | 7083348 B | 06-09-1995 |
| | | | JP | 62258530 A | 11-11-1987 |

For more details about this annex : see Official Journal of the European Patent Office, No. 12/82